# EUROPEAN PATENT APPLICATION

(11) **EP 1 123 905 A2**
(43) Date of publication of application: **16.08.2001**
(21) Application number: 01301190.3
(22) Date of filing: 12.02.2001
(51) Int. Cl.: C03C 17/22

(54) **Process for forming an optical composite film and for producing optical articles from the same**

(30) Priority: 10.02.2000 JP 2000034096; 29.11.2000 JP 2000362927
(71) Applicant: C. ITOH FINE CHEMICAL CO. LTD., Chiyoda-ku, Tokyo (JP); MURAYAMA, Yoichi, Shinjyuku-ku, Tokyo (JP); Kashiwagi, Kunihiro, Shiki-shi, Saitama (JP)
(72) Inventor: Murayama, Yoichu, Shinjuku-ku, Tokyo (JP); Kashiwagi, Kunihiro, Shiki-shi, Saitama (JP)
(74) Representative: Calamita, Roberto

(57) **Abstract**

The invention provides a process for forming an optical composite film that has a desired refractive index and is easy in design of the film. The material of an inorganic optical film is deposited on a base through reactive ion plating in an atmosphere where organic substance gases containing a fluorinated hydrocarbon are introduced, thus to form an organic composite film having a refractive index different from the intrinsic refractive index of the material of an inorganic optical film.

## Description

### FIELD OF THE INVENTION

The present invention relates to a process for forming an optical composite film and optical articles where the film is used. More specifically, it relates to a process wherein an optical composite film having a desired refractive index is formed by compounding a raw material for an inorganic optical film with organic substances in the preparation of the film.

### DESCRIPTION OF THE RELATED ART

Products used for optical purposes such as eyeglasses, liquid crystals, optical disks, or dichroic mirrors in particular contain optical films having desired functions according to the purposes. Anti-reflection films, one of the typical optical films, include lowly refractive films, multi-layer interference films, and porous films. Of these, the lowly refractive films that have zinc oxide or silicon oxide deposited through evaporation are in common use.
In the lowly refractive films, when light goes vertically into the interface between mediums different in refractive index n, characteristics of producing a difference in the phase of light are utilized. For example, when a lowly refractive film is formed on a base such as glass or plastics, light incident on the film eliminates light reflected on the glass or plastics to realize the lowly refractive film. When the optical film thickness nd of a film is designed to be λ/4 (λ: wavelength of an incident ray) , the difference of the phase of the incident ray reaches a maximum at 180°, and the reflectance becomes a minimum. For example, take a single layer film as an example; the refractive index of the single layer film is designed to be equal to the square root of the refractive index of a material forming the surface of an article such as glass and to become λ/4 in film thickness. Thus, the anti-reflection films are widely put to practical use.
A number of proposals have been made as to constitution of these anti-reflection films and processes for forming these films (Japanese Patent Application Nos. 11-119002 and 8-282279). However, the intrinsic refractive indices of film materials largely limit design of the film; the design is limited only to combination of materials and control of the thickness of film and the number of films.
The invention, which has been carried out under these circumstances, aims at solving these problems in the related art and at providing a process for forming an optical composite film having a desired refractive index and facilitating the design thereof, and articles produced by use of the film.

### SUMMARY OF THE INVENTION

What the invention provides for solving the aforesaid problems is as follows.
First, the invention provides a process for forming an optical composite film wherein a material for an inorganic optical film is deposited on a base through reactive ion plating in an atmosphere where organic substance gases containing a fluorinated hydrocarbon are introduced to form an optical composite film having a refractive index different from the intrinsic refractive index of the inorganic optical film itself.
The invention provides a process for forming an optical composite film, secondly, characterized in that material for the inorganic optical film is SiO₂; thirdly, that the inorganic optical film is of ITO (indium tin oxide) ; fourthly, that the organic substance gases are gases comprising a fluorinated hydrocarbon; fifthly, that the organic substance gases comprise the fluorinated hydrocarbon and at least one kind of substance selected from saturated hydrocarbon, unsaturated hydrocarbons, organic oxygen-containing compounds, organic silicon compounds, and organic oxygen-containing high polymeric compounds; and sixthly, that the organic substance gases contained together with a fluorinated hydrocarbon and at least one kind of gas selected from CH₄, C₂H₆, C₂H₄, C₂H₂, PMMA, and HMDSO.
Furthermore, the invention provides a process for forming an optical composite film, seventhly, characterized in that a multi-layer film is formed by a combination of any one of the aforesaid methods with at least one method selected from vacuum deposition, sputtering, and ion plating; and eighthly, that the optical composite film formed has a protective film provided thereon or the optical composite film is subjected to annealing.
In addition, ninthly, the invention also provides optical articles produced by use of the optical composite films formed by any one of the aforesaid processes of the invention.

### BRIEF DESCRIPTION OF THE DRAWINGS

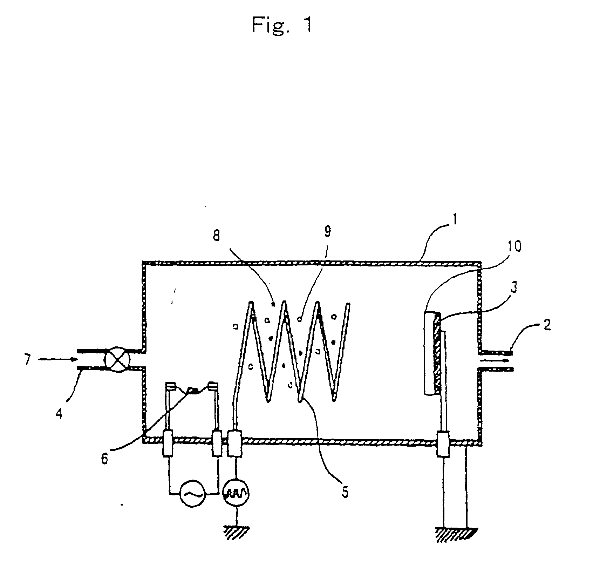

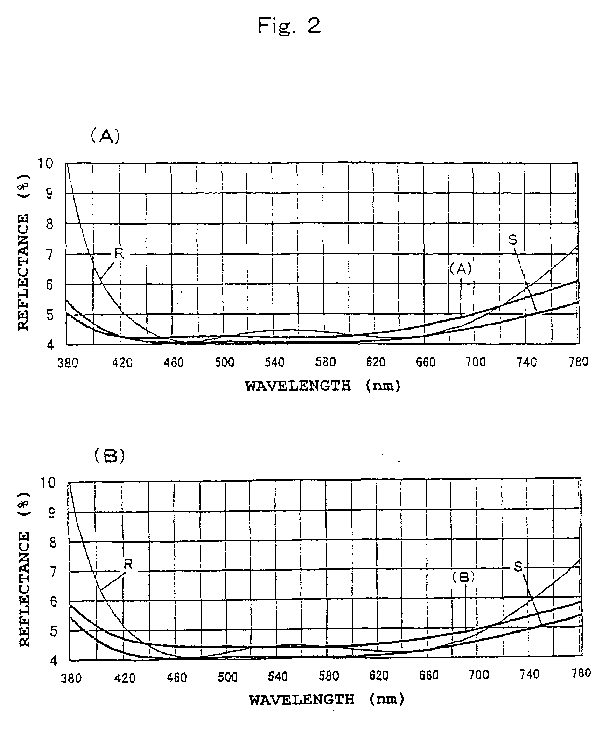

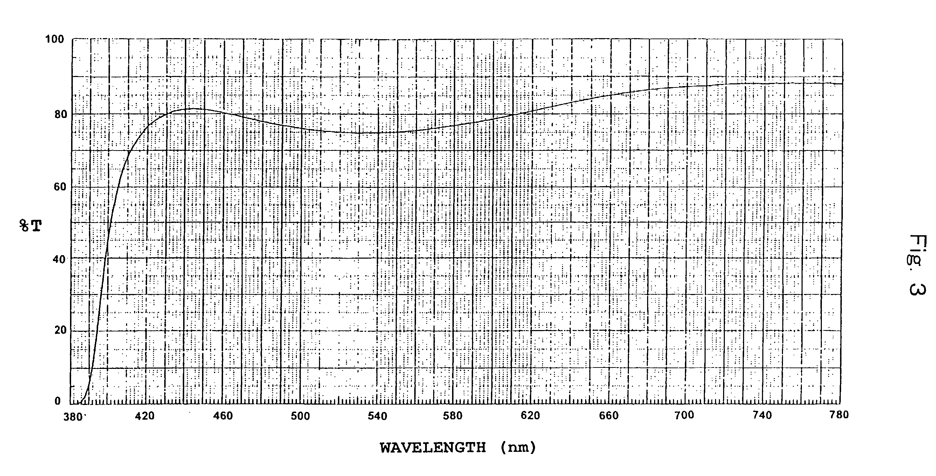

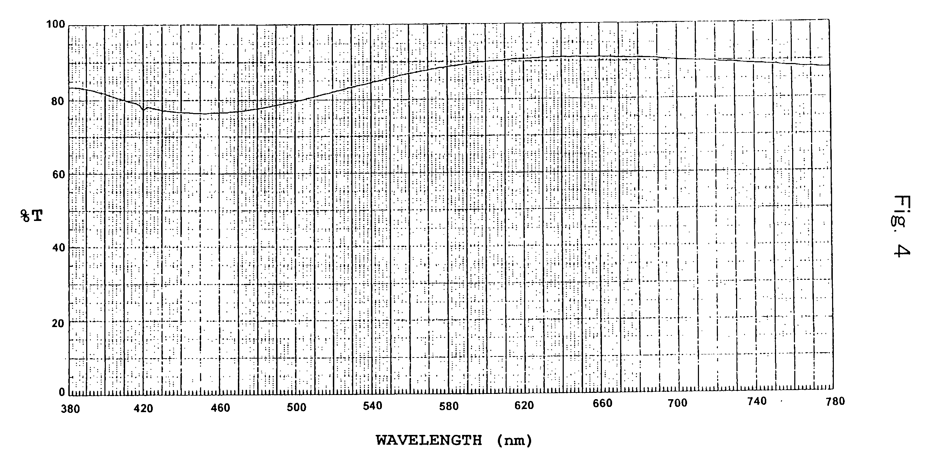

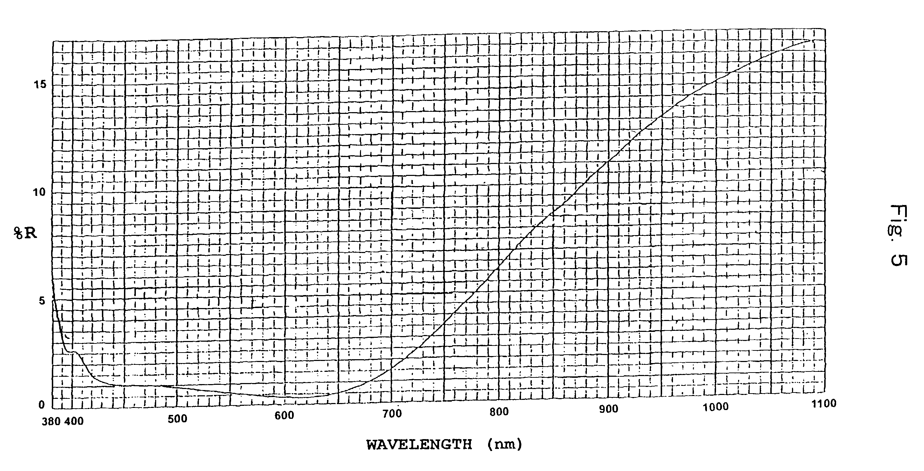

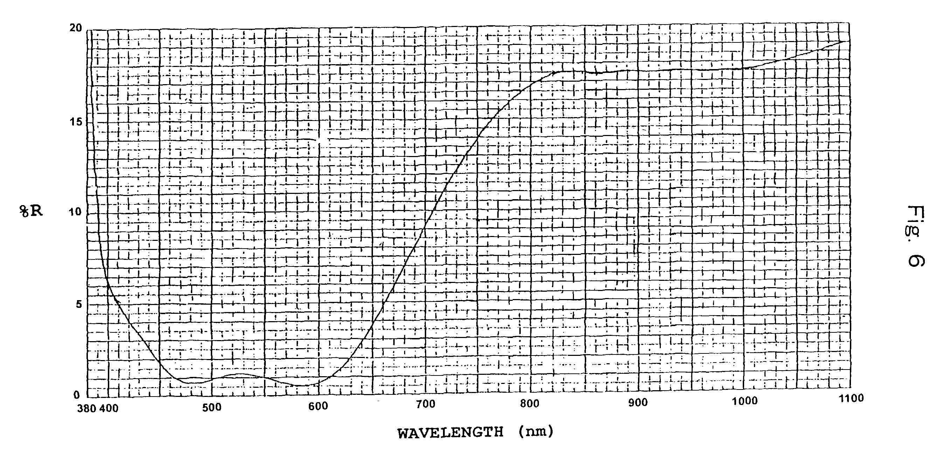

Fig. 1 is a drawing showing an outline of the formation of an optical composite film according to the process of the invention; Fig. 2 is a chart showing spectral reflection curves of anti-reflection films and spectral reflection curves thereof by design simulation; Fig. 3 is a chart showing the transmittance curve of an ITO film article formed on a PC plate; Fig. 4 is a chart showing the transmittance curve of an ITO film article formed on a glass plate; Fig. 5 is a chart showing a characteristic of the reflectance of a multi-layer film; and Fig. 6 is a chart showing a characteristic of the reflectance of another multi-layer film.

### DETAILED DESCRIPTION OF THE INVENTION

Embodiments of the invention, which has the aforesaid characteristics, are illustrated below.

In the processes for forming the optical composite film provided by the invention, a material for an inorganic optical film is deposited on a base through the reactive ion plating in an atmosphere where organic substance gases containing a fluorinated hydrocarbon are introduced, thus to form an optical composite film having a refractive index different from the intrinsic refractive index of the inorganic optical film itself.

The fluorinated hydrocarbons used in the invention are substances represented by a general formula CₙHₘF₁ (n and 1 each are a number of 1 or more; m is a number of 0 or 1 or more; and m+1 is 2n or 2n+2) and more preferably, substances represented by a general formula Cₙf₂ₙ₊₂, the formula corresponding to m = 0 and 1 = 2n+2 in the above formula. These substances are compounded to change the refractive indices of the materials of the inorganic optical films. Examples of preferred fluorinated hydrocarbons include CF₄, C₃F₆, C₃F₈, etc.

The organic substance gas can be composed only of a fluorinated hydrocarbon as described above or can be a combination of the fluorinated hydrocarbon with one kind or more of compounds selected from saturated hydrocarbons, unsaturated hydrocarbons, organic oxygen-containing compounds, organic silicon compounds, and organic oxygen-containing polymeric compounds. Examples thereof include polymethyl methacrylate (PMMA) that is a typical optical polymer, polycarbonates (PC), polyethylene terephthalate (PET), polytetrafluoroethylene, PFA, SITOP, and hexamethyldisiloxane (HMDSO) , and moreover, (C₃F₆)₃, (CF₃)₂=CFOCH₃, CF₂CFCl, acetylene, ethylene, etc. These organic subsatnces can be used singly as a matter of course, but also in admixture of a plurality of the substances.

The materials for inorganic optical films in general include those in common use. Examples thereof include materials having high refractive indices such as ITO (indium tin oxide) , Al₂O₃, SnO₂, ZrO₂, and TiO₂ as well as materials having low refractive indices such as SiO₂ and MgF₂.

About the bases, the materials thereof also are not particularly limited; for example, plastic materials such as PC and PET, metalic materials such as stainless steel and aluminium, and inorganic bases such as glass can be widely used as the bases.

An outline of the formation of an optical composite film provided by the invention is shown in Fig. 1.

In the processes of the invention, for example, as shown in Fig. 1, organic substance gases containing a fluorinated hydrocarbon (7) are introduced through feed opening (4) into vacuum chamber (1) where material for inorganic optical film (6) is set up, and optical composite film (10) is formed on base (3) through the reactive ion plating.

The reactive ion plating in general can be carried out according to known procedures. For example, a radio frequency is applied to radio-frequency coil (5) set up within vacuum chamber (1), and material for inorganic optical film (6) undergoes radio-frequency excitation thereby to generate low temperature plasma (8) . Since organic substance gases (7) are ionized or activated simultaneously with material for inorganic optical film (6), organic substance gases (7) are present as substance ions (9) . Base (3) is set up in the dark area to plasma, and electrons having high kinetic energy allow base (3) to have automatically negative potential, an electric field being produced. Consequently, the electric field accelerates low temperature plasma (8) of the material of an inorganic optical film and substance ions (9) of the organic substance gases, which attach to base (3) to form optical composite film (10). The formation of an optical composite film also can be carried out, for example, by use of plasma CVD apparatus proposed by the present inventors (Japanese Patent Laid-Open No. 33935/1989).

Optical composite film (10) formed on base (3) as described above comes to form a state where organic substances are homogeneously incorporated into the material of an inorganic optical film as if the substances are binders. Therefore, the resulting optical composite film (10) can have good adhesion to the base.

Furthermore, the temperature of base (3) , the output of a radio frequency, and the kind and pressure of organic substance gases (7) can be adjusted according to the materials of base (3) and material for an inorganic optical film (6) selected. Thus, the thickness and composition of optical composite film (10) can be precisely controlled.

This enables the formation of an optical composite film having a desired refractive index different from the intrinsic refractive index of the material for an inorganic optical film without deterioration in transparency that is fundamental characteristics of optical materials. In the design of an anti-reflection film, this makes it easy to adjust the reflective index and also makes it very useful to simulate the reflectance.

The invention provides a process for forming an optical composite film characterized in that the material of an inorganic optical film is SiO₂ in the aforesaid processes of the invention.

Si0₂ is a material used widely not only as an optical material but also for an anti-reflection film. SiO₂ is compounded with a fluorinated hydrocarbon, more preferably CF₄, according to the aforesaid procedure to form a film. The refractive index of the optical composite film thus obtained takes a value lower than that of the intrinsic refractive index (n) of SiO₂ (n = 1.46). Furthermore, adjustment of the amount of a fluorinated hydrocarbon introduced enables the preparation of a SiO₂ film having a desired refractive index.

This makes it possible to realize a low refractive index of a desired value expected to an anti-reflection film by use of SiO₂ that is an inexpensive, common optical material.

Furthermore, use of ITO (indium tin oxide) as the material of an inorganic optical film enables the formation of an optical film having electrical conductivity as well as the characteristics of a low refractive index.

In the formation of the optical composite film of the invention, the composition of a gas selected from C₂H₂, PMMA, and HMDSO with a fluorinated hydrocarbon allows improvement in adhesion of the film to a base and acquirement of an effect of protecting the film from breaking. The composition of CF₄ with HMDSO enables increase in stability of the resulting optical composite film.

These organic substance gases are compounded in order to improve properties of the materials for an inorganic optical film and impart further functions to the materials . Therefore, it is a matter of course that a variety of organic substances other than the aforesaid organic substances can be compounded. In addition, there is a possibility that a material for an optical film having novel characteristics is created.

In the processes of the invention, it is possible to form a multi-layer film according to any one of the aforesaid processes for forming an optical composite film, or according to a combination of the process and at least one method of vacuum deposition, sputtering, and ion plating.

For the optical films including anti-reflection films, for example, multi-layer films where multi-layer interference is utilized also are considered. The formation of these multi-layer films can be carried out according to any one of the processes for forming an optical composite film of the invention or according to a combination of the process and at least one method of vacuum deposition, sputtering, and ion plating. For example, layers having high refractive indices are formed through vacuum deposition, sputtering, or ion plating whereas layers having low refractive indices are formed according to the processes of the invention.

An optical composite film formed according to any one of the aforesaid processes can have a protective film formed thereon or is subjected to annealing.

The protective film is formed as a top layer from a material with high hardness, for example, through the reactive ion plating. On the other hand, the annealing is carried out, for example, by heating the resulting optical composite film to a suitable temperature and then slowly cooling.

This enables improvement in surface hardness of the resulting optical composite film and also age stability of the film. In addition, from the annealing, the effects of improving adhesion of the optical composite film or removing strain can be expected.

The invention provides optical articles produced by use of the optical composite films formed according to any one of the aforesaid processes.

The optical articles produced by use of the optical composite films formed according to the aforesaid processes of the invention include parts having anti-reflection films such as lenses, edge filters, and dichroic mirrors. Since the optical composite films are formed by compounding the organic substances, the films have excellent adhesion to bases, excellent durability, and high surface hardness. Furthermore, since the films are produced according to the processes having a high degree of freedom for design, high-quality optical composite films having desired refractive indices are realized.

This provides optical articles having high quality and high optical characteristics.

Examples are shown according to accompanying drawings below, and embodiments of the invention are illustrated in further detail.

### EXAMPLES

### EXAMPLE 1

An optical composite film where SiO₂ and CF₄ were compounded was formed on a glass plate under design of 3/4 λ thickness. The amount of CF₄ compounded was changed in five levels by adjusting the pressure of CF₄ to form films of samples 1 to 5. The respective conditions for forming films are shown in Table 1.

Just after forming the films and after the elapse of 10 days, the resulting optical composite films were checked as to the refractive index, adhesion, pencil hardness, and shift width of wavelength. Results are shown in Table 1. The shift widthof wavelength, which is represented by a unit "nm" , herein means the shift width of the peak of a central wavelength in a period of time from just after forming a film till after the elapse of 10 days.

**Table 1**

| Sample | | 1 | 2 | 3 | 4 | 5 |
|---|---|---|---|---|---|---|
| CF₄ Gas Pressure (×10⁻² Pa) | | 2 | 3 | 4 | 6 | 8 |
| Output of Radio frequency (W) | | 100 | 100 | 100 | 100 | 100 |
| Film-Forming Rate (Å/S) | | 3 | 3 | 3 | 3 | 3 |
| Temperature of Base (°C) | | Ordinary Temp. | Ordinary Temp. | Ordinary Temp. | Ordinary Temp. | Ordinary Temp. |
| Refractive Index | Just After Forming Film | 1.378 | 1.321 | 1.273 | 1.273 | 1.263 |
| | After Elapse of 10 Days | 1.381 | 1.321 | 1.279 | 1.281 | 1.239 |
| Adhesion | | 0/100 | 100/100 | 100/100 | 100/100 | 100/100 |
| Pencil Hardness | | HB | HB | B or less | HB | B |
| Shift Width of Wavelength (nm) | | 24 | 36 | 58 | 16 | 42 |

Table 1 reveals that the composition of CF₄ and SiO₂ (n = 1.46) enables reduction in refractive indices of the optical composite films. Furthermore, it also was found that as the amount of CF₄ compounded is increased, the refractive indices of the optical composite films decrease. All samples underwent no great change in refractive index after the elapse of 10 days after forming the films; the refractive indices of the optical composite films were found to be stable.

Sample 4 where the film is formed under a CF₄ gas pressure of 6×10⁻² Pa indicates the minimum shift width and pencil hardness as high as HB, a high-quality film being obtained.

### EXAMPLE 2

Al₂O₃ films were formed as first layers on glass plates through vacuum deposition (VD) A and radio-frequency ion plating (RF-IP) B, respectively. Optical composite films where SiO₂ and CF₄ were compounded were formed thereon as second layers under the same conditions as those adopted in the preparation of sample 4 in Example 1 to form anti-reflection films.

These conditions for forming the films are shown in Table 2. Spectral reflection curves of the resulting anti-reflection films are shown in Fig. 2A and 2B. In the figures, (A) and (B) indicate measurements of the spectral reflection characteristics, and S indicates values depending upon design simulation. For comparison, the spectral reflection curve of an inorganic four-layer anti-reflection film where the first and third layers are TiO₂ films , and the second and fourth layers are SiO₂ films is represented by R.

The reflectance at a wavelength of 550 nm and the results of a pencil hardness test and an adhesion test of the resulting anti-reflection films also are shown in Table 2.

**Table 2**

| Sample | | A | B |
|---|---|---|---|
| Second Layer | | SiO₂+CF₄ | |
| CF₄ Gas Pressure (×10⁻² Pa) | | 6 | |
| Output of Radio-frequency (W) | | 100 | |
| Film-Forming Rate (Å/S) | | 3 | |
| Temperature of Base (°C) | | Ordinary Temperature | |
| First Layer | | Al₂O₃ | |
| Method for Forming Film | | VD | RF-IP |
| O₂ Gas Pressure (×10⁻² Pa) | | - | 1.5 |
| Output of Radio Frequency (W) | | - | 700 |
| Film-Forming Rate (Å/S) | | 5 | 5 |
| Temperature of Base (°C) | | 300 | 300 |
| Reflectance | Just After Forming Film | 4.22 | 4.39 |
| | After Elapse of 2 Days | 4.82 | 4.81 |
| Adhesion | | 100/100 | 100/100 |
| Pencil Hardness | | B | B |

The results of Table 2 show that the reflectance of the resulting anti-reflection films increases a little after the elapse of two days after forming the films. The adhesion and film hardness of the anti-reflection films were found to be good.

Fig. 2 reveals that the reflectance of samples A and B are close to that by design simulation, and it was confirmed that anti-reflection films having low reflectance in the entire region of visible rays of wavelength of 460 to 620 nm were obtained.

In particular, sample A where the Al₂O₃ film of the first layer was formed through the vacuum deposition and the second layer was formed at a CF₄ gas pressure of 6x10⁻² Pa was found to have very good reflective characteristics.

### EXAMPLE 3

<1> A single-layer composite film where CF₄ and HMDSO were compounded with SiO₂ was formed on a glass plate so as to be 3/4 λ in thickness. The conditions for forming films are as shown in Table 3. Four compositions of introduced gases consisting of CF₄ and HMDSO were set up so as to be 6×10⁻² Pa in total gas pressure to form films of samples 6 to 9.
The refractive index, adhesion, pencil hardness, and sift width of wavelength of the resulting composite films were checked just after forming the films and after the elapse of a month. Results are shown in Table 3. The shift width of wavelength, which is represented by a unit "nm", herein means the shift width of the peak of a central wavelength in a period of time from just after forming a film till after the elapse of a month.
<2> Similarly to Example 2, an Al₂O₃ film was formed as a first layer on a glass plate through the vacuum deposition (VD). Subsequently, a composite film having a thickness of 2/4 λ where CF₄ and HMDSO were compounded with SiO₂ was formed as a second layer similarly to the aforesaid <1>, thus to form films of samples 10 to 13. The resulting films were checked as to the shift width after the elapse of a month after forming the films and adhesion. Results are shown in Table 3.

**Table 3**

| Conditions for Forming Composite Film | | | | | | |
|---|---|---|---|---|---|---|
| CF₄ Gas Pressure (×10⁻² Pa) | | | 6.0 | 5.5 | 4.5 | 4.5 |
| HMDSO Gas Pressure (×10⁻² Pa) | | | - | 0.5 | 1.5 | 1.5 |
| Output of Radio frequency (W) | | | 100 | 100 | 100 | 700 |
| Film-Forming Rate (Å/S) | | | 3 | 3 | 3 | 3 |
| Temperature of Base (°C) | | | Ordinary Temp. | Ordinary Temp. | Ordinary Temp. | Ordinary Temp. |
| (1) | Sample (Single-Layer Film) | | 6 | 7 | 8 | 9 |
| | Refractive Index (%) | Just After Forming Film | 1.273 | 1.275 | 1.345 | 1.375 |
| | | After Elapse of a Month | 1.292 | 1.287 | 1.390 | 1.422 |
| | Pencil Hardness | | HB | B | B | HB |
| | Shift Width of Wavelength (nm) | | 16 | 14 | 86 | 8 |
| (2) | Sample (Two-Layer Film) | | 10 | 11 | 12 | 13 |
| | Adhesion | | 0/100 | 100/100 | 100/100 | 100/100 |
| | Shift Width of Wavelength (nm) | | Not Measurable | 76 | 12 | 20 |

Table 3 shows that increase in amount of HMDSO compounded leads to increase in reflectance in the single layer films (sample 6 to 9) and decrease in shift width of wavelength in the two layer films (samples 11 to 13).
Sample 10 corresponds to sample A in Example 2 where an Al₂O₃ film was formed as a first layer, and a (SiO₂+CF₄) film was formed as a second layer. Sample 10 suffered breaking of the film in an adhesion test after the elapse of a month, resulting in poor adhesion. However, the composition of HMDSO (samples 11 to 13) was found to prevent the films from breaking to form composite films having good adhesion.
In addition, it was confirmed that samples 9 and 13 where the films were formed by applying a radio frequency showed small shift width to form composite films stable in aging.
These results show that the composition of CF₄ and HMDSO with Si0₂ and the formation of a composite film by a high radio frequency lead to decrease in the intrinsic refractive index of SiO₂, decrease in shift of the wavelength, and improvement in adhesion of the film.

### EXAMPLE 4

An optical composite film where CF₄ was compounded with ITO (indium tin oxide) was formed on a glass plate under design of λ/4 thickness. The amount of CF₄ compounded was changed in five levels by adjusting the gas pressure of CF₄ induced to form films of samples 14 to 18. The respective conditions for forming the films are as shown in Table 4.

The refractive index, adhesion, pencil hardness, and shift width of wavelength of the optical composite films were checked just after forming the films and after the elapse of 10 days. Results also are shown in Table 4. The shift width of wavelength, which is represented by a unit "nm" , herein means a shift width of the peak of a central wavelength in a period of time from just after forming a film till after the elapse of 10 days.

**Table 4**

| Sample | | 14 | 15 | 16 | 17 | 18 |
|---|---|---|---|---|---|---|
| CF₄ Gas Pressure (×10⁻² Pa) | | 2 | 3 | 4 | 6 | 8 |
| Output of Radio Frequency (W) | | 100 | 100 | 100 | 100 | 100 |
| Film-Forming Rate (Å/S) | | 3 | 3 | 3 | 3 | 3 |
| Temperature of Base (°C) | | Ordinary Temp. | Ordinary Temp. | Ordinary Temp. | Ordinary Temp. | Ordinary Temp. |
| Refractive Index | Just After Forming | 1.830 | 1.780 | 1.730 | 1.650 | 1.620 |
| | Film After Elapse of 10 Days | 1.840 | 1.790 | 1.750 | 1.650 | 1.635 |
| Adhesion | | 100/100 | 100/100 | 100/100 | 100/100 | 100/100 |
| Pencil Hardness | | HB | HB | HB | HB | B |
| Shift Width of Wavelength (nm) | | 10 | 10 | 20 | 5 | 15 |

The results of Table 4 confirm that the composition of CF₄ with ITO (n = 1.920) enables reduction in refractive indices of the optical composite films. Furthermore, increase in amount of CF₄ compounded was found to cause reduction in refractive indices of the optical composite films. All samples bring about no great change in refractive indices after the elapse of 10 days; the refractive indices of the optical composite films were found to be stable.

### EXAMPLE 5

An ITO film of 2000Å thickness was formed on a PC plate under the same conditions as those for sample 16 in Table 4 to obtain a chart of Fig. 3, which shows that the film can be used as an optical film.

### EXAMPLE 6

An ITO film of 2000Å thickness was formed on a glass plate under the same conditions as those for sample 18 in Table 4 to obtain a chart of Fig. 4, which shows that the film can be used as a high-quality optical film.

### EXAMPLE 7

An optical multi -layer film was formed under the conditions for forming the film of sample 15 in Table 4 to check the characteristics thereof.

That is, an optical film is formed on a PC plate through radio-frequency ion plating by compounding CF₄ with ITO, and an Al₂O₃ film and a SiO₂ film were laminated in a λ/4 wavelength to form an optical anti-reflection film having four layers on both surfaces.

An electrically conductive AR film (anti-reflection film) was obtained wherein the electrical conductivity of ITO was utilized.

The optical characteristics of the resulting film indicate that the film is a high-quality anti-reflection film as shown in Fig. 5.

The constitution of the electrically conductive film is as follows:

| | |
|---|---|
| Base | PC |
| First Layer | ITO+CF₄ |
| Second Layer | SiO₂ |
| Third Layer | ITO+CF₄ |
| Fourth Layer | Al₂O₃ |

The film causes no breaking after forming the film, and similarly causes no breaking after standing at ordinary temperature and after moistening.

In addition to a glass plate and a PC plate, it was confirmed that a single layer film or a multi-layer film formed by ITO+CF₄ could be formed on a PET plate and a PMMA plate.

### EXAMPLE 8

An electrically conductive AR film was formed on a glass plate through the radio-frequency ion plating under the conditions for forming the film of sample 17 in Table 4.

The constitution of the electrically conductive film is as follows:

| | |
|---|---|
| Base | Glass Plate |
| First Layer | ITO+CF₄ |
| Second Layer | SiO₂ |
| Third Layer | TiO₂ |
| Fourth Layer | SiO₂ |

An optical film where CF₄ was compounded with ITO, and SiO₂, TiO₂, and SiO₂ films were laminated in λ/4 wavelength to form a four-layer optical anti-reflection film.

The film thus formed did not change at ordinary conditions and after moistening as shown in Fig. 6, and exhibited characteristics as an electrically conductive AR film.

The invention is not to be construed as being limited by the examples as described above. It is a matter of course that a variety of embodiments different in particulars are possible.

As described above in detail, the invention provides a process for forming an optical composite film that has excellent adhesion to bases and excellent durability, and furthermore enables design having a high degree of freedom.

## Claims

1. A process for forming an optical composite film wherein a material of an inorganic optical film is deposited on a base through reactive ion plating in an atmosphere where organic substance gases containing a fluorinated hydrocarbon are introduced, thus to form an optical composite film having a refractive index different from an intrinsic refractive index of the inorganic optical film.

2. The process as described in claim 1 wherein the material of an inorganic optical film is SiO₂.

3. The process as described in claim 1 wherein the material of an inorganic optical film is ITO.

4. The process as described in any one of claims 1 to 4 wherein the organic substance gases comprise a fluorinated hydrocarbon and at least one kind of compound selected from saturated hydrocarbons, unsaturated hydrocarbons, organic oxygen-containing compounds, organic silicon compounds, and organic oxygen-containing polymeric compounds.

5. The process as described in claim 5 wherein the organic substance gases contained together with a fluorinated hydrocarbon are at least one kind of gas selected from CH₄, C₂H₆, C₂H₄, C₂H₂, PMMA, and HMDSO.

6. A process for forming an optical composite film wherein a multi-layer film is formed by a combination of a process as described in any one of claims 1 to 6 with at least one kind of method of vacuum deposition, sputtering, and ion plating.

7. A process for forming an optical composite film wherein an optical composite film formed by a process as described in any one of claims 1 to 7 has a protective film formed thereon or is subjected to annealing.

8. An optical article produced by use of the optical composite film that is formed according to a process as described in any one of claims 1 to 8.
